# EUROPEAN PATENT APPLICATION

(11) **EP 4 407 657 A1**
(43) Date of publication of application: **31.07.2024**
(21) Application number: 22872620.4
(22) Date of filing: 22.08.2022
(51) Int. Cl.: H01L 21/20, C30B 25/18, C30B 29/38, H01L 21/205

(54) **NITRIDE SEMICONDUCTOR SUBSTRATE AND METHOD FOR PRODUCING SAME**

(30) Priority: 21.09.2021 JP 2021152843
(71) Applicant: Shin-Etsu Handotai Co., Ltd., Tokyo 100-0004 (JP)
(72) Inventor: KUBONO Ippei, Annaka-shi, Gunma 379-0196 (JP); HAGIMOTO Kazunori, Annaka-shi, Gunma 379-0196 (JP)
(74) Representative: Mooser, Sebastian Thomas
(86) International application number: PCT/JP2022/031572
(87) International publication number: WO 2023/047864

(57) **Abstract**

The present invention provides a nitride semiconductor substrate including a growth substrate, and a nitride semiconductor thin film formed on the growth substrate, in which the nitride semiconductor thin film includes an AlN layer formed on the growth substrate and a nitride semiconductor layer formed on the AlN layer, and an average concentration of Y (Yttrium) in the AlN layer is 1E15 atoms/cm³ or higher and 5E19 atoms/cm³ or lower. Thereby, provided is a nitride semiconductor substrate capable of improving the surface morphology of an AlN layer, thereby suppressing the generation of pits on the surface of a nitride semiconductor epitaxial wafer, and a method for manufacturing the nitride semiconductor substrate.

## Description

### TECHNICAL FIELD

The present invention relates to a nitride semiconductor substrate and a method for manufacturing the substrate.

### BACKGROUND ART

MOCVD, one of the methods for producing a semiconductor thin film, is widely used because of its superiority in diameter enlargement, mass productivity, and ability to form a homogeneous thin film crystal. A nitride semiconductor represented by GaN is expected to be a semiconductor material for the next generation, exceeding the limitation of Si as the material.

GaN has characteristics of high saturated electron velocity and thus can produce a device capable of high-frequency operation and operable at a higher output due to a large dielectric breakdown electric field. Moreover, weight reduction, miniaturization, and lower electric power consumption can be expected. In recent years, the demand for an accelerated communication speed represented by such as 5G and an accompanying higher output has attracted attention toward a GaN HEMT operable at high frequency and high output.

A Si substrate is the most inexpensive substrate used for a GaN epitaxial wafer to produce a GaN device and is also advantageous for the enlargement of diameter. In addition, a large-diameter substrate for GaN epitaxial growth (hereinafter, a support substrate for GaN) with a large diameter and a thermal expansion coefficient close to that of GaN is also disclosed in such as Patent Document 1. This support substrate for GaN is configured with a support structure including a polycrystalline ceramic core, a first adhesive layer, a conductive layer, a second adhesive layer, and a barrier layer; a planarization layer laminated to one surface of the support structure; and a single crystal silicon layer laminated to the planarization layer.

Using such a support substrate for GaN, a GaN epitaxial substrate with a large diameter, a thick epitaxial layer, and crack-free can be manufactured. Moreover, such a support substrate has an extremely small difference in thermal expansion coefficient from GaN, thus, a warp is less likely to occur during growing and cooling GaN. Consequently, not only the warp of the substrate after film formation can be controlled to a small degree but also the epitaxial film formation time can be shortened, because complicated stress relaxation layers provided in the epitaxial layer is unnecessary, resulting in significant cost reduction for the epitaxial growth. Furthermore, the support substrate for GaN is mostly ceramics; thus, not only the substrate is a very hard substrate and less likely to develop plastic deformation, but also, the substrate does not generate wafer cracks, which has not been solved in large diameter GaN/Si.

Incidentally, both on a Si substrate and on a support substrate for GaN growth, pit generation on the epitaxial wafer surface is often a problem in group III nitride semiconductor film formation, as represented by GaN. This is partly due to a poor surface morphology of AlN formed directly above the Si substrate or the GaN growth substrate. When pits are generated on the surface of the epitaxial wafer, carriers necessary for device operation are lost, resulting in killer defects and thus lowered yield.

### CITATION LIST

### PATENT LITERATURE

Patent Document 1: JP 2020-505767 A

### SUMMARY OF INVENTION

### TECHNICAL PROBLEM

The present invention has been made in view of the above-described problem. An object of the present invention is to provide a nitride semiconductor substrate capable of improving the surface morphology of an AlN layer, thereby suppressing the generation of pits on the surface of a nitride semiconductor epitaxial wafer, and a method for manufacturing the nitride semiconductor substrate.

### SOLUTION TO PROBLEM

To achieve the object, the present invention provides a nitride semiconductor substrate comprising:
a growth substrate; and
a nitride semiconductor thin film formed on the growth substrate, wherein
the nitride semiconductor thin film includes an AlN layer formed on the growth substrate and a nitride semiconductor layer formed on the AlN layer, and
an average concentration of Y (Yttrium) in the AlN layer is 1E15 atoms/cm³ or higher and 5E19 atoms/cm³ or lower.

When the average concentration of Y in the AlN layer is within this range, the surface morphology of the AlN does not deteriorate, and thus, a nitride semiconductor substrate can be made with suppressed pit generation on the surface.

Preferably, a thickness of the AlN layer is 50 to 150 nm, and an average concentration of Y (Yttrium) from directly above the growth substrate to 300 nm in a thin film growth direction in the nitride semiconductor thin film is 1E15 atoms/cm³ or higher and 5E19 atoms/cm³ or lower.

In this way, the AlN layer in the nitride semiconductor thin film is sufficiently covered by an Yttrium-containing region; thus, the AlN layer with excellent surface morphology can be more reliably formed and suppress the pit generation on the surface of the nitride semiconductor thin film.

Moreover, the nitride semiconductor layer preferably comprises one or more of GaN, AlN, and AlGaN.

In the present invention, such a nitride semiconductor layer can be provided on the AlN layer.

Furthermore, preferably, the growth substrate is a substrate having a single-crystal silicon layer formed on a composite substrate with a plurality of layers laminated together, and
the nitride semiconductor thin film is formed on the single-crystal silicon layer.

According to such a growth substrate, a nitride semiconductor epitaxial growth substrate having a large diameter, a thick epitaxial layer, and crack-free can be manufactured. In addition, owing to the small difference in the thermal expansion coefficient from the nitride semiconductor, a warp is less likely to occur during nitride semiconductor growth and cooling; consequently, the warp of the substrate after film formation can be controlled to a small degree.

In this case, the single-crystal silicon layer preferably has a thickness of 100 to 500 nm.

The single crystal silicon layer can have such a thickness.

Preferably, the composite substrate includes a polycrystalline ceramic core, a first adhesive layer laminated entirely to the polycrystalline ceramic core, a second adhesive layer laminated entirely to the first adhesive layer, and a barrier layer laminated entirely to the second adhesive layer, and
the single-crystal silicon layer is formed on a planarization layer laminated to only one surface of the composite substrate.

In such a configuration, the growth substrate is largely made of ceramics. Therefore, not only the substrate itself is very hard and is not susceptible to plastic deformation, and but also wafer crack, which has not been solved with the silicon substrate, does not occur.

Moreover, the composite substrate may include a conductive layer laminated entirely to the first adhesive layer, between the first adhesive layer and the second adhesive layer.

Conductivity can be provided to the composite substrate as needed.

Furthermore, the composite substrate may include a polycrystalline ceramic core, a first adhesive layer laminated entirely to the polycrystalline ceramic core, a barrier layer laminated entirely to the first adhesive layer, a second adhesive layer laminated to a back surface of the barrier layer, and a conductive layer laminated to a back surface of the second adhesive layer, and
the single-crystal silicon layer may be formed on a planarization layer laminated on a front surface of the barrier layer of the composite substrate.

The nitride semiconductor substrate using such a growth substrate does not form a leakage path due to the conductive layer on the surface side of the growth substrate and can have excellent high-frequency characteristics.

In addition, the composite substrate may include a polycrystalline ceramic core, a first adhesive layer laminated entirely to the polycrystalline ceramic core, a conductive layer laminated to a back surface of the first adhesive layer, a second adhesive layer laminated to a back surface of the conductive layer, a barrier layer laminated to a front surface and a side surface of the first adhesive layer, a side surface of the conductive layer, and a side surface and a back surface of the second adhesive layer, and
the single-crystal silicon layer may be formed on a planarization layer laminated on a front surface of the barrier layer of the composite substrate.

The nitride semiconductor substrate using such a growth substrate also does not form a leakage path due to the conductive layer on the surface side of the growth substrate and can have excellent high-frequency characteristics.

In this case, the conductive layer preferably includes a polysilicon layer.

In addition, the conductive layer preferably has a thickness of 150 to 500 nm.

The conductive layer can be such a layer.

In this case, the polycrystalline ceramic core preferably contains aluminum nitride.

With such a composite substrate, the difference in the thermal expansion coefficient from that of the nitride semiconductor can be extremely small.

Moreover, the first adhesive layer and the second adhesive layer preferably include a tetraethyl orthosilicate (TEOS) layer or a silicon oxide (SiO₂) layer, and the barrier layer contains silicon nitride.

Furthermore, the first adhesive layer and the second adhesive layer preferably have a thickness of 50 to 200 nm, and the barrier layer has a thickness of 100 to 350 nm.

The thickness of the first adhesive layer, the second adhesive layer, and the barrier layer can have such a layer thickness.

In addition, the planarization layer preferably contains tetraethyl orthosilicate (TEOS) or silicon oxide (SiO₂) and has a thickness of 500 to 3000 nm.

The planarization layer can be such a layer.

Moreover, the present invention provides a method for manufacturing a nitride semiconductor substrate having a growth substrate and a nitride semiconductor thin film formed on the growth substrate, the method comprising the steps of:
(1) providing the growth substrate containing Y (Yttrium); and
(2) epitaxially growing an AlN layer on the growth substrate and then epitaxially growing a nitride semiconductor layer on the AlN layer, thereby forming the nitride semiconductor thin film, wherein
   in the step (2), Y in the growth substrate is diffused so that an average concentration of Y (Yttrium) in the AlN layer is 1E15 atoms/cm³ or higher and 5E19 atoms/cm³ or lower.

In this way, when the growth substrate contains a predetermined amount of Y (Yttrium), Y can be relatively easily diffused to the AlN layer in a predetermined concentration.

In addition, the AlN layer preferably has a thickness of 50 to 150 nm and
an average concentration of Y (Yttrium) from directly above the growth substrate to 300 nm in a thin film growth direction in the nitride semiconductor thin film is preferably 1E15 atoms/cm³ or higher and 5E19 atoms/cm³ or lower.

In this way, the AlN layer is sufficiently coated by a Yttrium-containing region in the nitride semiconductor thin film; thus, the AlN layer having excellent surface morphology can be formed more reliably, and generation of a pit on the surface of the nitride semiconductor thin film can be suppressed.

Preferably, the growth substrate is configured with a composite substrate including a polycrystalline ceramic core containing Yttria (Y₂O₃) as a bonding material, a first adhesive layer laminated entirely to the polycrystalline ceramic core, a second adhesive layer laminated entirely to the first adhesive layer, and a barrier layer laminated entirely to the second adhesive layer; a planarization layer laminated to only one surface of the composite substrate; and a single-crystal silicon layer formed on the planarization layer; and the nitride semiconductor thin film is formed on the single-crystal silicon layer, and
the average concentration of Y (Yttrium) in the AlN layer is 1E15 atoms/cm³ or higher and 5E19 atoms/cm³ or lower by adjusting a thickness of the barrier layer in advance.

According to such a manufacturing method, Y with a predetermined concentration can be diffused more easily and reliably.

Furthermore, the composite substrate can include a conductive layer laminated entirely to the first adhesive layer, between the first adhesive layer and the second adhesive layer.

Conductivity can be provided to the composite substrate as needed.

Furthermore, the growth substrate may be configured with a composite substrate including a polycrystalline ceramic core containing Yttria (Y₂O₃) as a bonding material, a first adhesive layer laminated entirely to the polycrystalline ceramic core, a barrier layer laminated entirely to the first adhesive layer, a second adhesive layer laminated to a back surface of the barrier layer, and a conductive layer laminated to a back surface of the second adhesive layer; a planarization layer laminated to a front surface of the barrier layer of the composite substrate; and a single-crystal silicon layer formed on the planarization layer; and the nitride semiconductor thin film is formed on the single-crystal silicon layer, and
the average concentration of Y (Yttrium) in the AlN layer may be 1E15 atoms/cm³ or higher and 5E19 atoms/cm³ or lower by adjusting a thickness of the barrier layer in advance.

Such a method for manufacturing the nitride semiconductor substrate can manufacture the nitride semiconductor substrate with excellent high-frequency characteristics, in which a leakage path due to the conductive layer on the front surface side of the composite substrate is not generated.

In addition, the growth substrate may be configured with a composite substrate including a polycrystalline ceramic core containing Yttria (Y₂O₃) as a bonding material, a first adhesive layer laminated entirely to the polycrystalline ceramic core, a conductive layer laminated to a back surface of the first adhesive layer, a second adhesive layer laminated to a back surface of the conductive layer, and a barrier layer laminated to a front surface and a side surface of the first adhesive layer, a side surface of the conductive layer, and a side surface and a back surface of the second adhesive layer; a planarization layer laminated to a front surface of the barrier layer of the composite substrate; and a single-crystal silicon layer formed on the planarization layer; and the nitride semiconductor thin film is formed on the single-crystal silicon layer, and
the average concentration of Y (Yttrium) in the AlN layer may be 1E15 atoms/cm³ or higher and 5E19 atoms/cm³ or lower by adjusting a thickness of the barrier layer in advance.

Such a method for manufacturing the nitride semiconductor substrate can also manufacture the nitride semiconductor substrate with excellent high-frequency characteristics, in which a leakage path due to the conductive layer on the front surface side of the composite substrate is not generated.

### ADVANTAGEOUS EFFECTS OF INVENTION

As described above, the present invention can provide a nitride semiconductor substrate capable of improving the surface morphology of an AlN layer, thereby suppressing the generation of pits on the surface of a nitride semiconductor epitaxial wafer, and a method for manufacturing the nitride semiconductor substrate.

### BRIEF DESCRIPTION OF DRAWINGS

FIG. 1 is a view illustrating an example of a schematic view of a nitride semiconductor substrate according to the present invention.
FIG. 2 is a view illustrating an example of a schematic view of a growth substrate used for the present invention.
FIG. 3 is a SIMS profile of an Epi-structure 1 on a support substrate for GaN with a barrier layer having 100 nm in Example 1.
FIG. 4 is a SIMS profile of an Epi-structure 2 on a support substrate for GaN with a barrier layer having 200 nm in Example 1.
FIG. 5 is an example of a SEM image (Epi-structure 1) at an interface between an epitaxial layer of a nitride semiconductor substrate and a growth substrate obtained in Example.
FIG. 6 is a SIMS profile of Epi-structure 1 on a support substrate for GaN with a 1000 nm barrier layer in Comparative Example 1.
FIG. 7 is a SIMS profile of Epi-structure 2 on a support substrate for GaN with a 1000 nm barrier layer in Comparative Example 1.
FIG. 8 is a SEM image (Epi-structure 1) at an interface between Epi and a substrate in Comparative Example 2.
FIG. 9 is a cross-sectional TEM image (Epi-structure 1) of a pit generated on the surface of a nitride semiconductor thin film in Comparative Example 2.
FIG. 10 is a graph illustrating a relationship between an average concentration of Y in an AlN layer and the number of pits on the surface of a GaN layer in two levels of Epi-structures.
FIG. 11 is a graph illustrating a relationship between an average concentration of Y in an AlN layer and a thickness of the barrier layer in two levels of Epi-structures.
FIG. 12 is a view illustrating another example of a schematic view of a growth substrate used for the present invention.
FIG. 13 is a view illustrating still another example of a schematic view of a growth substrate used for the present invention.

### DESCRIPTION OF EMBODIMENTS

As described above, when a group III nitride semiconductor is formed on a Si substrate or a support substrate for GaN growth, a pit is generated on the surface of an epitaxial wafer, which is a problem. This is partly because the AlN layer formed directly above the Si substrate or GaN growth substrate has a poor surface morphology.

The present inventors have studied an improvement of the surface morphology of the AlN layer to suppress the generation of the pit on the epitaxial wafer surface and found out that Yttrium contained in a predetermined concentration in a nitride semiconductor thin film on a growth substrate improves the surface morphology of the AlN layer and suppresses the generation of the pit. Based on this finding, the present invention has been completed.

That is, the present invention is a nitride semiconductor substrate including a growth substrate and a nitride semiconductor thin film formed on the growth substrate, in which the nitride semiconductor thin film includes an AlN layer formed on the growth substrate and a nitride semiconductor layer formed on the AlN layer, and an average concentration of Y (Yttrium) in the AlN layer is 1E15 atoms/cm³ or higher and 5E19 atoms/cm³ or lower.

In addition, the present invention is a method for manufacturing a nitride semiconductor substrate having a growth substrate and a nitride semiconductor thin film formed on the growth substrate, and the method includes (1) providing the growth substrate containing Y (Yttrium) and (2) epitaxially growing an AlN layer on the growth substrate and then epitaxially growing a nitride semiconductor layer on the AlN layer, thereby forming the nitride semiconductor thin film, in which in the step (2), Y in the growth substrate is diffused so that an average concentration of Y (Yttrium) in the AlN layer is 1E15 atoms/cm³ or higher and 5E19 atoms/cm³ or lower.

Hereinafter, the present invention will be described in detail. However, the present invention is not limited thereto.

### [Nitride Semiconductor Substrate]

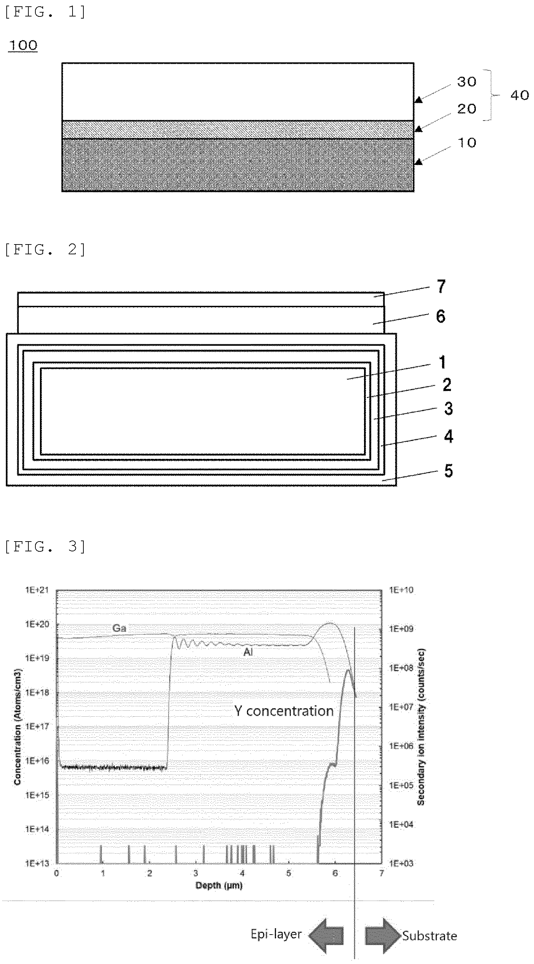

FIG. 1 shows an example of the inventive nitride semiconductor substrate. In the inventive nitride semiconductor substrate 100, a nitride semiconductor thin film 40 is formed on a growth substrate 10, and the nitride semiconductor thin film 40 includes an AlN layer 20 formed on the growth substrate 10 and a nitride semiconductor layer 30 formed on the AlN layer 20. The inventive nitride semiconductor substrate 100 is characterized by containing a predetermined amount of Yttrium in the AlN layer 20, and an average concentration of Y (Yttrium) in the AlN layer 20 is 1E15 atoms/cm³ or higher and 5E19 atoms/cm³ or lower.

By determining the average concentration of Y (Yttrium) in the AlN layer 20 to 1E15 atoms/cm³ or higher and 5E19 atoms/cm³ or lower, the surface morphology of the AlN layer is improved, and the generation of the pit on an epitaxial layer (nitride semiconductor layer 30) grown on the AlN layer can be suppressed. On the other hand, when the average concentration of Y in the AlN layer 20 is less than 1E15 atoms/cm³, a pit suppression effect is insufficient, and when higher than 5E19 atoms/cm³, inherent GaN characteristics are not obtainable.

A method for measuring the average concentration of Y (Yttrium) is not particularly limited but, for example, can be obtained by secondary ion mass spectroscopy (SIMS).

Further, in the inventive nitride semiconductor substrate, preferably, a thickness of the AlN layer is 50 to 150 nm, and an average concentration of Y (Yttrium) from directly above the growth substrate to 300 nm in a thin film growth direction in the nitride semiconductor thin film is 1E15 atoms/cm³ or higher and 5E19 atoms/cm³ or lower. In this way, the AlN layer in the nitride semiconductor thin film is sufficiently covered by an Yttrium-containing region; thus, the AlN layer with excellent surface morphology can be more reliably formed and suppress the pit generation on the surface of the nitride semiconductor thin film.

In the nitride semiconductor thin film, the nitride semiconductor layer formed on the AlN layer preferably comprises one or more of GaN, AlN, and AlGaN. In particular, a layer in which GaN is laminated on AlGaN or a layer in which a super-lattice structure composed of AlGaN, AlN, and GaN is laminated on AlGaN is more preferable. Furthermore, the total thickness of the nitride semiconductor thin film combining the AlN layer and the nitride semiconductor layer is not particularly limited but can be, e.g., 0.5 to 20 um, preferably 1 to 10 µm.

Preferably, the growth substrate is a substrate having a single-crystal silicon layer formed on a composite substrate with a plurality of layers laminated together, and then the nitride semiconductor thin film is formed further on the single-crystal silicon layer.

In addition, as a growth substrate, using the support substrate for GaN, as described below, is more preferable. The support substrate for GaN is, as shown in FIG. 2 for example, configured with a composite substrate (a support structure) including a polycrystalline ceramic core 1, a first adhesive layer 2 laminated entirely to the polycrystalline ceramic core 1, a conductive layer 3 laminated entirely to the first adhesive layer 2, a second adhesive layer 4 laminated entirely to the conductive layer 3, and a barrier layer 5 laminated entirely to the second adhesive layer 4; a planarization layer 6 laminated to only one surface of the composite substrate; and a single-crystal silicon layer 7 laminated to the planarization layer 6.

Incidentally, the conductive layer 3 and the first adhesive layer 2 are formed as needed, are not always present, and may be formed only on one surface.

At this point, the polycrystalline ceramic core 1 preferably contains aluminum nitride, is sintered using a sintering additive at a high temperature of such as 1800°C, and has a thickness of such as about 600 to 1150 um, and basically, often formed in the thickness of the SEMI standards for Si substrates.

The first adhesive layer 2 and the second adhesive layer 4 are preferably layers including a tetraethyl orthosilicate (TEOS) layer or a silicon oxide (SiO₂) layer, or both layers and are laminated by such as a LPCVD process or a CVD process and have a thickness of about 50 to 200 nm.

The conductive layer 3 preferably includes polysilicon, is laminated by such as the LPCVD process, and has a thickness of about 150 to 500 nm. This is a layer to provides conductivity and is doped with such as boron (B) or phosphorous (P). This conductive layer 3 containing polysilicon is formed as needed and is not always present and may be formed only on one surface.

The barrier layer 5 preferably contains a silicon nitride layer, is laminated by such as the LPCVD process, and has a thickness of about 100 to 350 nm.

The planarization layer 6 preferably contains tetraethyl orthosilicate (TEOS) or silicon oxide (SiO₂), is laminated by such as the LPCVD process, and has a thickness of about 500 nm to 3000 nm. This planarization layer is laminated to planarize the top surface and may be such as typical ceramic film materials, e.g., SiO₂, Al₂O₃, Si₃N₄, or silicon oxynitride (SiₓO_{y}N_{z}).

The single crystal silicon layer 7 preferably has a thickness of about 100 to 500 nm. This is a layer utilized as a growth surface for other epitaxial growth such as GaN and bonded to the planarization layer 6 using such as layer transferring process.

Incidentally, for each layer, the thickness, manufacturing methods, materials used, etc., are not limited to the values described above, and not all layers are necessarily present.

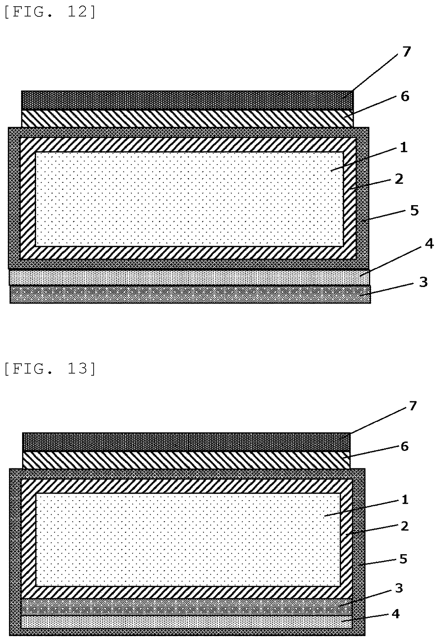

In addition, another example of the support substrate (growth substrate) for GaN, as shown in FIG. 12, for example, can be configured with a composite substrate including a polycrystalline ceramic core 1, a first adhesive layer 2 bonded entirely to the polycrystalline ceramic core, a barrier layer 5 bonded entirely to the first adhesive layer, a second adhesive layer 4 bonded to a back surface of the barrier layer, and a conductive layer 3 bonded to a back surface of the second adhesive layer; a planarization layer 6 bonded only to a front surface of the composite substrate; and a single-crystal silicon layer 7 bonded to the planarization layer.

Such a nitride semiconductor substrate using the growth substrate with a structure in which the conductive layer 3 is formed only on the back surface side does not generate a leakage path due to the conductive layer on the front surface side of the growth substrate when producing a high-frequency device, resulting in excellent high-frequency characteristics.

In addition, still another example of the support substrate (growth substrate) for GaN, as shown in FIG. 13, for example, can be configured with a composite substrate including a polycrystalline ceramic core 1, a first adhesive layer 2 bonded entirely to the polycrystalline ceramic core, a conductive layer 3 bonded to a back surface of the first adhesive layer, a second adhesive layer 4 bonded to a back surface of the conductive layer, and a barrier layer 5 bonded to a front surface and a side surface of the first adhesive layer, a side surface of the conductive layer, and a side surface and a back surface of the second adhesive layer; a planarization layer 6 bonded only to a front surface of the composite substrate; and a single-crystal silicon layer 7 bonded to the planarization layer.

Even a nitride semiconductor substrate using the growth substrate with a structure in which the conductive layer 3 is formed only on the back surface side does not generate a leakage path due to the conductive layer on the front surface side of the growth substrate when producing a high-frequency device, resulting in excellent high-frequency characteristics.

### [Method for Manufacturing Nitride Semiconductor Substrate]

Hereinafter, the inventive method for manufacturing a nitride semiconductor substrate is described.

### [First Aspect]

In a first aspect of the inventive method for manufacturing the nitride semiconductor substrate, a growth substrate containing Y (Yttrium) is provided (Step (1)), and when a nitride semiconductor thin film is epitaxially grown on the growth substrate, Y in the growth substrate is diffused, thereby making an average concentration of Y (Yttrium) in an AlN layer within a predetermined range (Step (2)).

### <Step (1)>

The step (1) is a step to provide the growth substrate containing Y (Yttrium).

To begin with, the growth substrate containing Y, which is a substrate for epitaxial growth, is manufactured. The growth substrate is not particularly limited as long as the substrate contains Y; for example, a support substrate for GaN, as described above, can be used. By including yttria (Y₂O₃) as a bonding material (sintering additive, for example) in the polycrystalline ceramic core in the support substrate for GaN, yttria can be used as a Y source.

At this point, by adjusting the thickness of the barrier layer (silicon nitride layer) of the support substrate for GaN to be provided in advance, the amount of Yttrium diffused in the epitaxial layer can be controlled with ease in the step (2) as described later, and the average concentration of Y in the AlN layer is more reliably within the predetermined range. The thickness of the barrier layer can be, for example, 100 to 350 nm or less.

### <Step (2)>

The step (2) is a step of epitaxially growing an AlN layer on the growth substrate and then epitaxially growing a nitride semiconductor layer on the AlN layer, thereby forming the nitride semiconductor thin film. In the step, Y in the growth substrate is diffused so that an average concentration of Y (Yttrium) in the AlN layer is 1E15 atoms/cm³ or higher and 5E19 atoms/cm³ or lower.

In the step (2), for example, in a MOCVD reactor, the AlN layer (e.g., 50 to 150 nm), an AlGaN layer (100 to 2000 nm), and a group III nitride semiconductor thin film such as GaN is formed on the support substrate for GaN by epitaxial growth. In the case of the epitaxial growth, TMAl is used as an Al source, TMGa as a Ga source, and NH₃ as an N source. Moreover, the carrier gas is N₂ and H₂, or either of these gasses, and the process temperature is about 900 to 1200°C.

By performing such a step, the average concentration of Y in the AlN layer is made to be in a range of 1E15 atoms/cm³ or higher and 5E19 atoms/cm³ or lower. By making such Yttrium concentration, the surface morphology of AlN is improved, and the generation of a pit can be suppressed.

### [Second Aspect]

In addition, the inventive method for manufacturing the nitride semiconductor substrate is not limited to First Aspect described above. As a method to make Yttrium contained in the AlN layer, other than a method of diffusion as described above, Y source gas may flow during epitaxial growth of the AlN layer.

### EXAMPLE

Hereinafter, the present invention will be specifically described with reference to Example and Comparative Examples. However, the present invention is not limited thereto.

### (Example)

A support substrate for GaN was manufactured as a substrate for epitaxial growth. The support substrate for GaN was configured with a composite substrate including a polycrystalline ceramic core (an aluminum nitride core), a first adhesive layer (a silicon oxide layer) laminated entirely to the polycrystalline ceramic core, a conductive layer (a polysilicon layer) laminated entirely to the first adhesive layer, a second adhesive layer (silicon oxide layer) laminated entirely to the conductive layer, and a barrier layer (a silicon nitride layer) laminated entirely to the second adhesive layer; a planarization layer (a silicon oxide layer) laminated only to one surface of the composite substrate; and a single-crystal silicon layer formed on the planarization layer. The barrier layer had three levels of thicknesses, i.e., 100 nm, 200 nm, and 350 nm, and yttria (Y₂O₃) was contained as a Y source in the polycrystalline ceramic core.

Then, in a MOCVD reactor, group III nitride semiconductor thin films, such as AlN, AlGaN, and GaN, were grown by epitaxial growth on the manufactured support substrate for GaN. The support substrate for GaN was mounted on a wafer pocket called a satellite. During the epitaxial growth, TMAl was used as an Al source, TMGa as a Ga source, and NH₃ as an N source. Moreover, the carrier gas was N₂ and H₂, and the process temperature was 1200°C.

When the support substrate for GaN was mounted on the satellite and epitaxial growth was performed, epitaxial layers were grown from the substrate side to growth direction in the order of AlN and AlGaN, and then GaN was epitaxially grown. Two levels of epitaxial layer structures were produced (Epi-structures 1 and 2).

### <Epi-structure 1>

A 150 nm AlN layer and a 150 nm AlGaN layer were formed, and then an about 3 um so-called super-lattice structure was formed by repeatedly forming AlGaN, AlN, and GaN in several nm order. A GaN layer was formed thereon. The total epitaxial layer had a total film thickness of 6.5 µm.

### <Epi-structure 2>

After forming a 150 nm AlN layer, an about 1.5 um AlGaN was formed so that the Al composition decreased toward the growth direction. A GaN layer was formed on top of that, and the total film thickness of the total epitaxial layer was made to 5.5 µm.

Both Epi-structures 1 and 2 were configured to have a device layer on the surface layer side of the epitaxial layer. The device layer had a structure having a high crystalline GaN layer (a channel layer) of about 400 nm, in which two-dimensional electron gas was generated, an AlGaN layer (a barrier layer) of about 20 nm for generating two-dimensional electron gas, and on the top layer, a GaN layer (a cap layer) of about 3 nm. The barrier layer was made to have an Al composition of 20%.

After the epitaxial growth, the number of pits on the surface was counted by a surface inspection and measurement apparatus and a microscope. In addition, by SIMS analysis (Secondary Ion Mass Spectrometry), Y (Yttrium) concentration in the epitaxial layer was measured. Moreover, a cross-section of an interface between the epitaxial layer and the growth substrate was observed by SEM (Scanning Electron Microscope), and the morphology of the AlN layer was confirmed.

### (Comparative Example 1)

In the step of producing a support substrate for GaN in Examples, the barrier layer was made to have a thickness of 500 nm, 800 nm, and 1000 nm. Using these substrates, the same epitaxial growth (2 levels) as in Example and similar evaluations were performed.

### (Comparative Example 2)

In the step of producing a support substrate for GaN in Examples, a substrate in which the polycrystalline ceramic core contains no yttria (Y₂O₃) was produced. In addition, the thickness of the barrier layer was made to 350 nm. Using the substrate, the same epitaxial growth (2 levels) as in Example and similar evaluations were performed. Moreover, a cross-sectional TEM image of a pit generated was observed.

### [Results of evaluation (Example)]

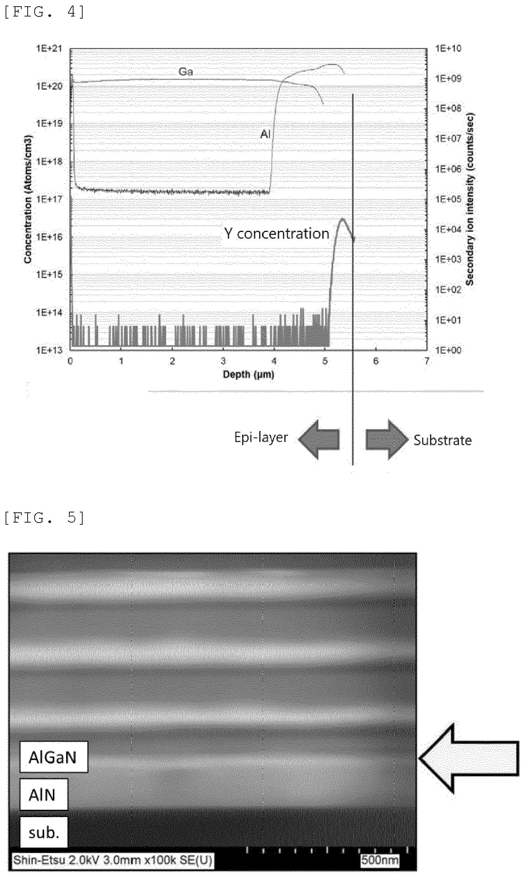

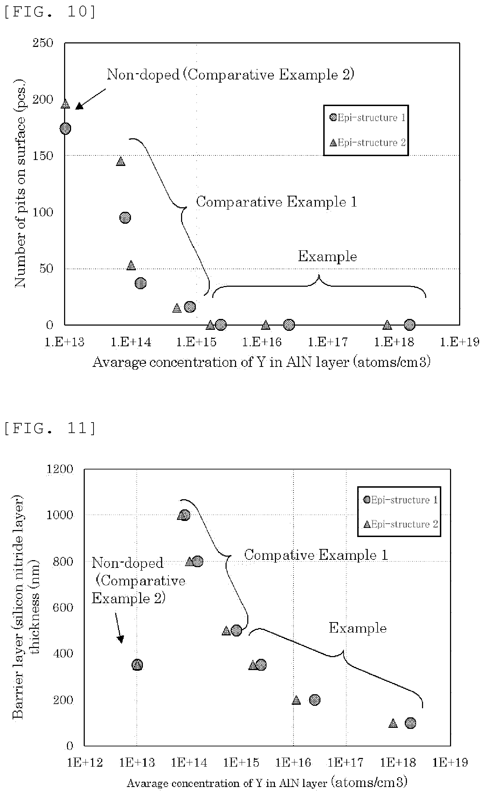

FIG. 3 and 4 show SIMS measurement results of the nitride semiconductor substrate of Epi-structure 1 in which the barrier layer had a thickness of 100 nm, and the nitride semiconductor substrate of Epi-structure 2 in which the barrier layer had a thickness of 200 nm, both of which were manufactured in Example. These nitride semiconductor substrate had a high Y concentration in the epitaxial layer near the interface between the epitaxial layer and the growth substrate, indicating that the average concentration of Y in the AlN layer directly above the growth substrate was within the range of 1E15 atoms/cm³ or higher and 5E19 atoms/cm³ or lower. Other nitride semiconductor substrates manufactured in Example had an average concentration of Y in the AlN layer within the range described above; it was confirmed that the thinner the barrier layer, the higher the average Y concentration (FIG. 11).

Moreover, from the results of SEM observation, in all of the nitride semiconductor substrates manufactured in Example, it was confirmed that the AlN layers formed directly above the substrate for film formation showed an excellent morphology (one example is shown in FIG. 5) .

Furthermore, in all of the nitride semiconductor substrates manufactured in Example, no pit on the surface was confirmed by observation of either a surface inspection and measurement apparatus or a microscope (FIG. 10).

### [Results of evaluation (Comparative Examples 1 and 2)]

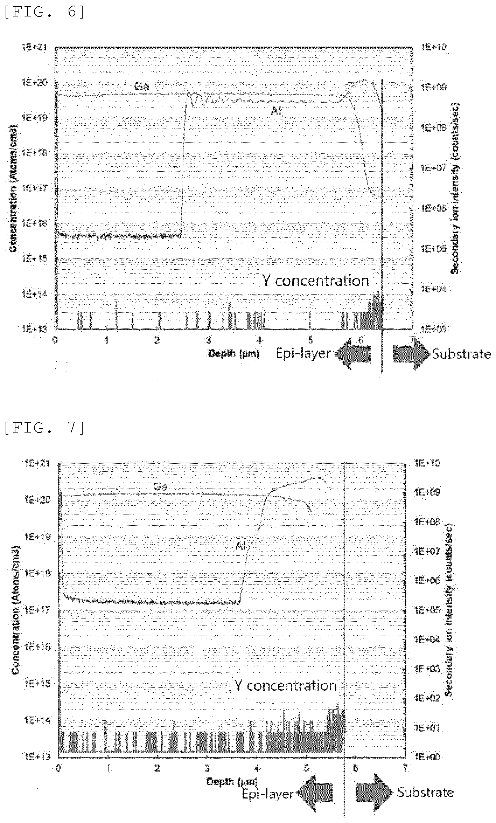

FIG. 6 and 7 show SIMS measurement results of nitride semiconductor substrates manufactured in Comparative Example 1 having Epi-structure 1 and Epi-structure 2, in which the barrier layer had a thickness of 1000 nm. These nitride semiconductor substrates had a Y concentration lower than the detection limit in the epitaxial layer near the interface between the epitaxial layer and the growth substrate, indicating that the average concentration of Y in the AlN layer directly above the growth substrate was less than 1E15 atoms/cm³. Other nitride semiconductor substrates manufactured in Comparative Examples 1 and 2 also had an average concentration of Y in the AlN layer less than 1E15 atoms/cm³; it was confirmed that the thicker the barrier layer the lower the average concentration of Y (FIG. 11) .

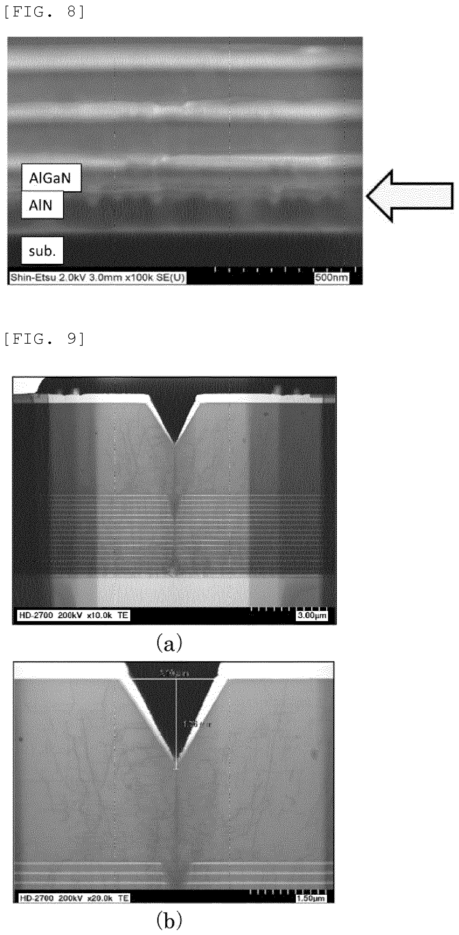

Furthermore, the results of SEM observation confirmed that all of the nitride semiconductor substrates manufactured in Comparative Examples 1 and 2 indicated a poor morphology on the AlN layer formed directly above the substrate for film formation (one example is shown in FIG. 8).

In addition, all of the nitride semiconductor substrates manufactured in Comparative Examples 1 and 2 were confirmed to have a number of pits generated on the surface by observations of a surface inspection and measurement apparatus or a microscope (see FIG. 10, described later). Moreover, FIG. 9 shows a TEM image of the pits generated on the surface (In FIG. 9, the image (b) is an enlarged image of the image (a).).

### [Examination for Evaluative Results]

As shown in a relation between an average concentration of Y in an AlN layer and the number of pits on a surface in FIG. 10, each Example (the inventive nitride semiconductor substrate) had an average concentration of Y in the AlN layer in a range within 1E15 atoms/cm³ or higher and 5E19 atoms/cm³ or lower, and thus the generation of pits on a surface was able to be suppressed; however, it was indicated that, when the average concentration of Y in the AlN layer was even a little less than 1E15 atoms/cm³ as in Comparative Example 1, the generation of pits on the surface was unable to be suppressed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A nitride semiconductor substrate comprising:
a growth substrate; and
a nitride semiconductor thin film formed on the growth substrate, wherein
the nitride semiconductor thin film includes an AlN layer formed on the growth substrate and a nitride semiconductor layer formed on the AlN layer, and
an average concentration of Y (Yttrium) in the AlN layer is 1E15 atoms/cm³ or higher and 5E19 atoms/cm³ or lower.

2. The nitride semiconductor substrate according to claim 1, wherein
a thickness of the AlN layer is 50 to 150 nm, and
an average concentration of Y (Yttrium) from directly above the growth substrate to 300 nm in a thin film growth direction in the nitride semiconductor thin film is 1E15 atoms/cm³ or higher and 5E19 atoms/cm³ or lower.

3. The nitride semiconductor substrate according to claim 1 or 2, wherein
the nitride semiconductor layer comprises one or more of GaN, AlN, and AlGaN.

4. The nitride semiconductor substrate according to any one of claims 1 to 3, wherein
the growth substrate is a substrate having a single-crystal silicon layer formed on a composite substrate with a plurality of layers laminated together, and
the nitride semiconductor thin film is formed on the single-crystal silicon layer.

5. The nitride semiconductor substrate according to claim 4, wherein
the single-crystal silicon layer has a thickness of 100 to 500 nm.

6. The nitride semiconductor substrate according to claim 4 or 5, wherein
the composite substrate includes a polycrystalline ceramic core, a first adhesive layer laminated entirely to the polycrystalline ceramic core, a second adhesive layer laminated entirely to the first adhesive layer, and a barrier layer laminated entirely to the second adhesive layer, and
the single-crystal silicon layer is formed on a planarization layer laminated to only one surface of the composite substrate.

7. The nitride semiconductor substrate according to claim 6, wherein
the composite substrate includes a conductive layer laminated entirely to the first adhesive layer, between the first adhesive layer and the second adhesive layer.

8. The nitride semiconductor substrate according to claim 4 or 5, wherein
the composite substrate includes a polycrystalline ceramic core, a first adhesive layer laminated entirely to the polycrystalline ceramic core, a barrier layer laminated entirely to the first adhesive layer, a second adhesive layer laminated to a back surface of the barrier layer, and a conductive layer laminated to a back surface of the second adhesive layer, and
the single-crystal silicon layer is formed on a planarization layer laminated on a front surface of the barrier layer of the composite substrate.

9. The nitride semiconductor substrate according to claim 4 or 5, wherein
the composite substrate includes a polycrystalline ceramic core, a first adhesive layer laminated entirely to the polycrystalline ceramic core, a conductive layer laminated to a back surface of the first adhesive layer, a second adhesive layer laminated to a back surface of the conductive layer, a barrier layer laminated to a front surface and a side surface of the first adhesive layer, a side surface of the conductive layer, and a side surface and a back surface of the second adhesive layer, and
the single-crystal silicon layer is formed on a planarization layer laminated on a front surface of the barrier layer of the composite substrate.

10. The nitride semiconductor substrate according to any one of claims 7 to 9, wherein
the conductive layer includes a polysilicon layer.

11. The nitride semiconductor substrate according to any one of claims 7 to 10, wherein
the conductive layer has a thickness of 150 to 500 nm.

12. The nitride semiconductor substrate according to any one of claims 6 to 11, wherein
the polycrystalline ceramic core contains aluminum nitride.

13. The nitride semiconductor substrate according to any one of claims 6 to 12, wherein
the first adhesive layer and the second adhesive layer include a tetraethyl orthosilicate (TEOS) layer or a silicon oxide (SiO₂) layer, and
the barrier layer contains silicon nitride.

14. The nitride semiconductor substrate according to any one of claims 6 to 13, wherein
the first adhesive layer and the second adhesive layer have a thickness of 50 to 200 nm, and the barrier layer has a thickness of 100 to 350 nm.

15. The nitride semiconductor substrate according to any one of claims 6 to 14, wherein
the planarization layer contains tetraethyl orthosilicate (TEOS) or silicon oxide (SiO₂) and has a thickness of 500 to 3000 nm.

16. A method for manufacturing a nitride semiconductor substrate having a growth substrate and a nitride semiconductor thin film formed on the growth substrate, the method comprising the steps of:
(1) providing the growth substrate containing Y (Yttrium); and
(2) epitaxially growing an AlN layer on the growth substrate and then epitaxially growing a nitride semiconductor layer on the AlN layer, thereby forming the nitride semiconductor thin film, wherein
in the step (2), Y in the growth substrate is diffused so that an average concentration of Y (Yttrium) in the AlN layer is 1E15 atoms/cm³ or higher and 5E19 atoms/cm³ or lower.

17. The method for manufacturing a nitride semiconductor substrate according to claim 16, wherein
the AlN layer has a thickness of 50 to 150 nm, and an average concentration of Y (Yttrium) from directly above the growth substrate to 300 nm in a thin film growth direction in the nitride semiconductor thin film is 1E15 atoms/cm³ or higher and 5E19 atoms/cm³ or lower.

18. The method for manufacturing a nitride semiconductor substrate according to claim 16 or 17, wherein
the growth substrate is configured with a composite substrate including a polycrystalline ceramic core containing Yttria (Y₂O₃) as a bonding material, a first adhesive layer laminated entirely to the polycrystalline ceramic core, a second adhesive layer laminated entirely to the first adhesive layer, and a barrier layer laminated entirely to the second adhesive layer; a planarization layer laminated to only one surface of the composite substrate; and a single-crystal silicon layer formed on the planarization layer; and the nitride semiconductor thin film is formed on the single-crystal silicon layer, and
the average concentration of Y (Yttrium) in the AlN layer is 1E15 atoms/cm³ or higher and 5E19 atoms/cm³ or lower by adjusting a thickness of the barrier layer in advance.

19. The method for manufacturing a nitride semiconductor substrate according to claim 18, wherein
the composite substrate includes a conductive layer laminated entirely to the first adhesive layer, between the first adhesive layer and the second adhesive layer.

20. The method for manufacturing a nitride semiconductor substrate according to claim 16 or 17, wherein
the growth substrate is configured with a composite substrate including a polycrystalline ceramic core containing Yttria (Y₂O₃) as a bonding material, a first adhesive layer laminated entirely to the polycrystalline ceramic core, a barrier layer laminated entirely to the first adhesive layer, a second adhesive layer laminated to a back surface of the barrier layer, and a conductive layer laminated to a back surface of the second adhesive layer; a planarization layer laminated to a front surface of the barrier layer of the composite substrate; and a single-crystal silicon layer formed on the planarization layer; and the nitride semiconductor thin film is formed on the single-crystal silicon layer, and
the average concentration of Y (Yttrium) in the AlN layer is 1E15 atoms/cm³ or higher and 5E19 atoms/cm³ or lower by adjusting a thickness of the barrier layer in advance.

21. The method for manufacturing a nitride semiconductor substrate according to claim 16 or 17, wherein
the growth substrate is configured with a composite substrate including a polycrystalline ceramic core containing Yttria (Y₂O₃) as a bonding material, a first adhesive layer laminated entirely to the polycrystalline ceramic core, a conductive layer laminated to a back surface of the first adhesive layer, a second adhesive layer laminated to a back surface of the conductive layer, and a barrier layer laminated to a front surface and a side surface of the first adhesive layer, a side surface of the conductive layer, and a side surface and a back surface of the second adhesive layer; a planarization layer laminated to a front surface of the barrier layer of the composite substrate; and a single-crystal silicon layer formed on the planarization layer; and the nitride semiconductor thin film is formed on the single-crystal silicon layer, and
the average concentration of Y (Yttrium) in the AlN layer is 1E15 atoms/cm³ or higher and 5E19 atoms/cm³ or lower by adjusting a thickness of the barrier layer in advance.
